# EUROPÄISCHE PATENTSCHRIFT

(11) **EP 0 350 766 B1**
(45) Veröffentlichungstag und Bekanntmachung des Hinweises auf die Patenterteilung: **07.09.1994**
(21) Anmeldenummer: 89112165.9
(22) Anmeldetag: 04.07.1989
(51) Int. Cl.: H03D 3/16

(54) **Frequenzdiskriminator für integrierte Schaltungen**
Frequency discriminator for integrated circuits
Discriminateur de fréquence pour circuits intégrés

(30) Priorität: 15.07.1988 DE 3824015
(43) Veröffentlichungstag der Anmeldung: 17.01.1990
(73) Patentinhaber: TEMIC TELEFUNKEN microelectronic GmbH, 74072 Heilbronn (DE)
(72) Erfinder: Böhme, Rolf, Dr., D-7107 Bad Friedrichshall (DE)
(74) Vertreter: Maute, Hans-Jürgen, Dipl.-Ing.

(56) Entgegenhaltungen:
- FR-A- 2 324 161
- PATENT ABSTRACTS OF JAPAN, Band 5, Nr. 7 (E-41)[679], 17. Januar 1981;& JP-A-55 136 707 (SONY K.K.) 24-10-1980
- IEEE TRANSACTIONS ON CONSUMER ELECTRONICS, Band CE-28, Nr. 3, August 1982,Seiten 393-407, IEEE, New York, US; TAIWA OKANOBU: "A complete single chip AM/FM radio integrated circuit"

## Beschreibung

Die Erfindung befaßt sich mit einer Schaltungsanordnung zur Demodulation frequenzmodulierter Schwingungen für integrierte Schaltungen, die nur einen Pin oder äußeren Anschluß für ein Selektionsmittel benötigt und sich wegen ihres niedrigen Strom- und Spannungsbedarfs auch für batteriebetriebene Geräte eignet. Ein typischer Anwendungsfall sind FM-Empfänger mit 10,7 MHz Zwischenfrequenz.

Eine häufig gewählte Ausführungsform von Frequenzdiskriminatoren besteht darin, das zu demodulierende Signal einmal direkt und einmal über ein phasenschiebendes Netzwerk den beiden Eingängen eines Multiplizierers zuzuführen. Das phasenschiebende Netzwerk besteht vorzugsweise aus einem kapazitiv angekoppelten Resonanzkreis und liefert eine Phasenverschiebung in der Umgebung von 90°. Da bei um 90° phasenverschobenen Signalen an den Eingängen eines Multiplizierers dessen mittleres Ausgangssignal verschwindet, ergibt sich bei Frequenzabweichungen und damit Phasenabweichungen am Schwingkreis ein Ausgangssignal proportional zur Frequenzabweichung.

Während die wesentlichen Bestandteile solcher Frequenzdiskriminatoren integrierbar sind, muß das phasenschiebende Netzwerk extern angeschlossen werden. Dazu werden außer der allgemeinen Erd- oder Bezugsklemme noch zwei weitere Anschlüsse der integrierten Schaltung benötigt.

Dies ist aus konstruktiven und wirtschaftlichen Gründen unerwünscht. Deshalb wurde in der "IEEE Trans. on Consumer Electronics, Vol. CE-28, No. 3, Aug. 82, S. 393-407", eine Schaltungsanordnung angegeben, die nur einen zusätzlichen Anschluß benötigt. Dabei wird eine Brückenschaltung aus 4 Impedanzen verwendet, wobei 3 Impedanzen ohmsche Widerstände sind und die vierte, extern gegen Masse angeschlossene Impedanz, ein Resonator mit einer Serienresonanz unterhalb der Mittenfrequenz und einer Parallelresonanz oberhalb der Mittenfrequenz ist. Ein solcher Resonator wirkt im Arbeits-Frequenzbereich induktiv. Die Brückenschaltung ist zwischen Ausgang des ZF-Verstärkers und Masse angeschlossen. Der erste Eingang des Multiplizierers ist am Ausgang des ZF-Verstärkers angeschlossen. Der zweite Eingang des Multiplizierers ist am Ausgang der Brückenschaltung angeschlossen.

Eine auf dem gleichen Prinzip basierende Schaltungsanordnung ist aus Patent Abstracts of Japan, Band 5, Nr. 7, E-41, 679, 17.01.1981 (JP-A 55 136 707) bekannt, bei der der den Resonator enthaltende Brückenzweig jeweils über den Emitter eines Transistors an den Eingang des phasenschiebenden Netzwerks angeschlossen ist, wobei jeweils ein Eingangsanschluß von den Basiselektroden der beiden Transistoren gebildet werden. Der erste Eingang des Multiplizierers ist an die beiden Emitter-Elektroden der genannten Transistoren angeschlossen, während der zweite Eingang des Multiplizierers mit dem Ausgang der Brückenschaltung verbunden ist.

Dieser Lösung haften jedoch noch mehrere Nachteile an. Für einen typischen Stromverteilungs-Multiplizierer werden Eingangsspannungen von etwa 100 mV benötigt. Da die Brückenschaltung eine Dämpfung von mindestens 6 dB aufweist, muß der Ausgang des ZF-Verstärkers mindestens 200 mV bereitstellen oder der Brückenschaltung ein Vorverstärker nachgeschaltet werden.

Die Impedanz der Brückenzweige darf bei der bekannten Schaltung nicht zu hoch sein, um das System unempfindlich gegen Streukapazitäten zu machen. Als Standardwert bei 10,7 MHz hat sich 1 kOhm eingebürgert. Entsprechend dieser Belastung muß der Ausgang des ZF-Verstärkers einen erheblichen Strom aufbringen.

Der Ausgang des ZF-Verstärkers einer integrierten Schaltung weist ein bestimmtes Ruhepotential auf. Die ordnungsgemäße Funktion des Stromverteilungsmultiplizierers erfordert die Bereitstellung geeigneter Ruhepotentiale für die Eingänge. Schließt man die Brückenschaltung zwischen Ausgang des ZF-Verstärkers und Masse an, so fließt ein unerwünschter Gleichstrom durch den Zweig mit ohmschen Widerständen. Die Einfügung einer Koppelkapazität unterdrückt zwar den Gleichstrom, erfordert aber wegen der niedrigen Impedanzen einen verhältnismäßig großen Kondensator. Um die Ruhepotentiale der Eingänge des Stromverteilungs-Multiplizierers herzustellen, werden entweder weitere Koppelkondensatoren oder auch Emitterfolger benötigt. Dabei entstehen aber auch zusätzliche Phasenfehler.

Die Aufgabe der Erfindung ist es, einen Frequenzdiskriminator anzugeben, der mit einer kleinen Eingangsspannung auskommt, keine Koppelkondensatoren benötigt und einen geringen Strombedarf hat. Diese Aufgabe wird durch einen Frequenzdiskriminator mit den kennzeichnenden Merkmalen des Anspruchs 1 gelöst.

Die Erfindung wird im folgenden an Ausführungsbeispielen näher erläutert. In der zugehörigen Zeichnung zeigen
- Figur 1: das Prinzip eines bekannten Brückendiskriminators,
- Figur 2: eine Ausführungsform der Erfindung,
- Figur 3: das Zeigerdiagramm der Spannungen und Ströme,
- Figur 4: eine Anordnung mit Potentialunterschied zwischen X- und Y-Eingang des Multiplizierers.

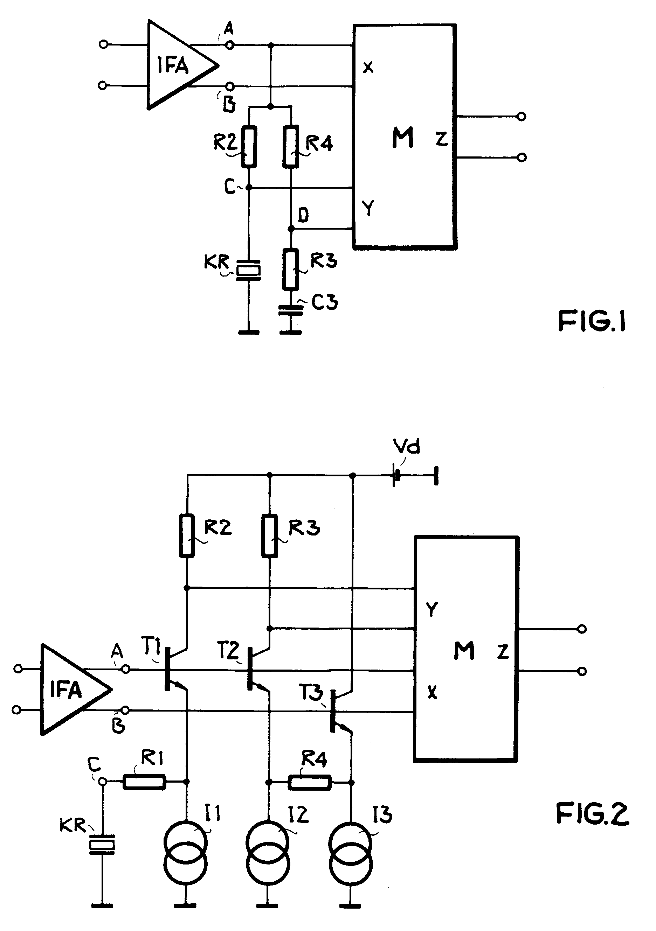

Die Figur 1 dient zur Erläuterung des Prinzips des bekannten Brückendiskriminators. Zwei Anschlüsse A, B stellen den Eingang des Diskriminators dar. Die beiden Anschlüsse A, B sind mit dem symmetrischen Ausgang eines ZF-Verstärkers IFA und dem X-Eingang eines Multiplizierers M verbunden. An einem Eingangsanschluß A ist die Brückenschaltung angeschlossen. Der erste Zweig der Brükke wird vom Widerstand R2 und vom Resonator KR gebildet. Der Verbindungspunkt C entspricht dem Pin einer integrierten Schaltung. Der zweite Zweig besteht aus den Widerständen R4, R3. Zur Unterdrückung eines Gleichstroms ist dem Widerstand R3 noch ein Koppelkondensator C3 in Reihe geschaltet. Beide Zweige der Brückenschaltung führen zum Massepunkt. Die Brückenspannung wird zwischen dem Punkt C und dem Verbindungspunkt D der Widerstände R3, R4 entnommen und dem Y-Eingang des Multiplizierers M zugeführt. Der Resonator KR kann als piezo-elektrischer Schwinger ausgebildet sein oder er kann auch aus einer Induktivität und zwei Kapazitäten bestehen. Er wirkt im Arbeitsfrequenzbereich induktiv, hat unterhalb eine Serienresonanz mit sehr kleiner Impedanz und oberhalb eine Parallelresonanz mit großer Impedanz.

Im Zeigerdiagramm der Brücke stehen die Spannungsabfälle über R2 und KR rechtwinklig aufeinander, während die Spannungsabfälle über R4 und R3 gleichgerichtet sind. Wählt man R3 = R4, so wird der Betrag der Brückenausgangsspannung unabhängig von der Frequenz, nur die Phase ist frequenzabhängig. Bei einer mittleren Frequenz, wenn die Impedanz des Resonators dem Widerstand R2 betragsgleich ist, ist die Phasenverschiebung zur Eingangsspannung VAB genau 90°. Aus den bekannten Eigenschaften des Multiplizierers M und einer Mittelwertbildung ergibt sich die vorgesehene Diskriminator-Funktion.

Bei der Ausführung als integrierte Schaltung erweist sich insbesondere die Kapazität C3 als Hürde, da die typischen Impedanzwerte der Brückenelemente von etwa 1 kΩ eine unangenehm große und damit flächenintensive Kapazität erfordern. Die Ausgangsspannung der Brücke beträgt bei idealen Elementen die Hälfte der Eingangsspannung zwischen A und Masse und damit ein Viertel der Eingangsspannung am Eingang A, B. Für den erwünschten Schaltbetrieb des Multiplizierers sind mindestens 100 mV am Y-Eingang erforderlich. Unter Berücksichtigung der Mute-Funktion und anderer Bedingungen kann ein Mehrfaches dieses Wertes erforderlich werden. Das bedeutet, daß am Eingang A, B des Diskriminators eine beachtliche Signalleistung bereit gestellt werden muß, was sich negativ auf Spannungs- und Strombedarf auswirkt.

Diese Nachteile werden durch die erfindungsgemäße Lösung nach Figur 2 beseitigt. Der Eingang A, B der Diskriminatorschaltung ist wie bei der bekannten Schaltung mit dem X-Eingang des Multiplizierers verbunden. Ein erster Transistor T1 ist mit seiner Basis am Eingang A angeschlossen, sein Emitter ist über einen Widerstand R1 mit dem Anschluß C und mit einer Stromquelle I1 verbunden. Sein Kollektor ist über einen Widerstand R2 mit der Versorgungsspannung Vd verbunden. Dieser Schaltungsteil liefert am Kollektor des ersten Transistors T1 eine Spannung, die durch den Einfluß des Resonators KR nach Betrag und Phasen veränderlich ist. Für die Erzeugung einer frequenzunabhängigen Spannung über dem Widerstand R3 dienen ein zweiter und ein dritter Transistor T2, T3, die mit ihren Basen am Eingang A bzw. B angeschlossen werden und deren Emitter über einen Widerstand R4 miteinander und mit je einer Stromquelle I2, I3 verbunden sind. Der Kollektor des zweiten Transistors T2 führt über einen Widerstand R3 und der Kollektor des Transistors T3 direkt zur Versorgungsspannung Vd.

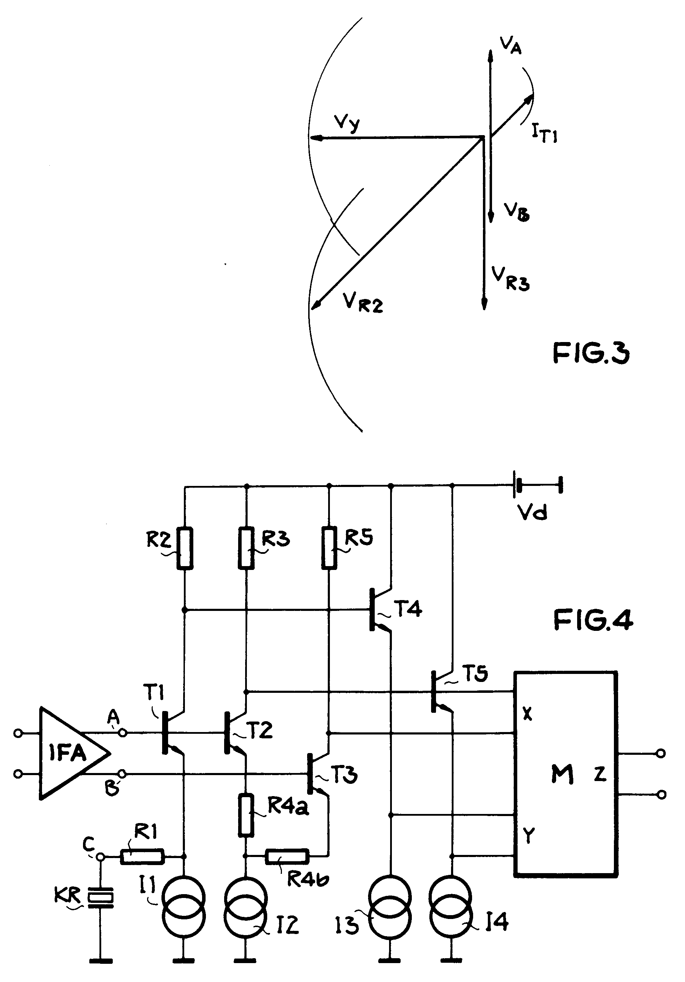

In der Figur 3 sind die maßgebenden Spannungen und Ströme dieser Anordnung als Zeiger dargestellt. Infolge der symmetrischen Eingangsspannung bilden die Zeiger der Spannungen VA, VB an den Eingangsanschlüssen A, B ein entgegengesetztes Zeigerpaar. Die Funktion des Transistors T1 als Emitterfolger überträgt die Spannung VA auf die Reihenschaltung von Resonator KR und Widerstand R1 und erzeugt den Strom IT1. In Abhängigkeit von der Frequenz bewegt sich die Spitze von IT1 auf einem Kreisbogen, wie in der Zeichnung angedeutet ist. Der Strom IT1 fließt aber auch, soweit man den Basisstrom vernachlässigen kann, im Kollektorkreis des Transistors T1 und erzeugt den Spannungsabfall VR2 über dem Widerstand R2. Aus einer ähnlichen Überlegung hinsichtlich des zweiten und dritten Transistors T2, T3 und des Widerstandes R4 folgt der Zeiger des Spannungsabfalls VR3 über dem Widerstand R3. Die Differenz Vy der Spannungen VR2, VR3 steht senkrecht auf VA und VB und ändert bei Frequenzänderungen nur die Phasen, nicht den Betrag. Sie ist die Spannung, die dem Y-Eingang des Multiplizierers M zugeführt wird.

Da über das Verhältnis der Widerstände R2, R1 und R3, R4 eine Verstärkung realisiert werden kann, bedarf es nicht der hohen Eingangsspannung VAB, wie in der Schaltung nach Figur 1. Entsprechend verkleinern sich die Ströme. Über die Wahl der Ströme und der Widerstände kann die Gleichkomponente der Spannung am Y-Eingang null gemacht werden, ohne daß ein Koppelkondensator benötigt wird.

Wenn die Ausgangsspannung des ZF-Verstärkers IFA nicht ausreicht oder wenn die Gleichpotentiale von Verstärkerausgang und X-Eingang des Multiplizierers M nicht harmonieren, kann das X-Signal nach Figur 4 auch an den Kollektoren der Transistoren T2, T3 entnommen werden. Zu diesem Zweck wird im Kollektorkreis des dritten Transistors T3 ein Arbeitswiderstand R5 eingefügt. Weiterhin ist in Figur 4 dem Y-Eingang des Multiplizierers M je ein Emitterfolger mit den Transistoren T4, T5 vorgeschaltet. Dadurch liegt das Eingangspotential des Y-Eingangs um eine Basis-Emitter-Spannung tiefer als das Eingangspotential des X-Eingangs, eine Voraussetzung für die Anwendung des Stromverteilungsmultiplizierers nach Gilbert.

Die Figur 4 zeigt außerdem eine Variante der Beschaltung der Emitter der Transistoren T2, T3. Die beiden Emitter der Transistoren T2, T3 sind über eine Reihenschaltung zweier Widerstände R4a, R4b miteinander verbunden. Am Verbindungspunkt der Widerstände R4a, R4b ist eine Stromquelle I23 angeschlossen. Diese Variante benötigt nur eine Stromquelle für die beiden Transistoren. Infolge des Gleichspannungsabfalls über den Widerständen R4a, R4b vermindert sich aber die Arbeitsspannung der Stromquelle.

## Patentansprüche

1. Frequenzdiskriminator für integrierte Schaltungen zur Demodulation eines frequenzmodulierten Eingangssignals, bestehend aus einem phasenschiebenden Netzwerk und einer Multiplizierschaltung (M), wobei das phasenschiebende Netzwerk einen symmetrischen Eingang (A, B) für das zu demodulierende Eingangssignal, eine Anschlußklemme (C) zum Anschluß eines Resonators (KR), der sich im Arbeits-Frequenzbereich induktiv verhält, einen ersten Ausgang, der mit dem Eingang (A, B) entweder direkt oder über eine Pufferstufe verbunden ist, so daß dessen Signalspannung keine oder nur eine geringe Phasenverschiebung gegenüber dem Eingangssignal hat, und einen zweiten Ausgang aufweist, dessen Signalspannung zum Eingangssignal frequenzabhängig phasenverschoben ist, die Multiplizierschaltung (M) zwei Eingänge (X, Y) und einen Ausgang (Z) aufweist und je ein Eingang (X, Y) der Multiplizierschaltung mit je einem Ausgang des phasenverschiebenden Netzwerkes verbunden ist und am Ausgang (Z) der Multiplizierschaltung das demodulierte Ausgangssignal abgegriffen werden kann, dadurch gekennzeichnet, daß ein erster Transistor (T1) mit der Basis an einer Eingangsklemme (A), mit dem Emitter an einer Stromquelle (I1) und über einen Widerstand (R1) an der Anschlußklemme (C) für den Resonator (KR) und mit dem Kollektor über einen Arbeitswiderstand (R2) an einer Versorgungsspannung (Vd) so angeschlossen ist, daß über dem Arbeitswiderstand (R2) ein gegenüber dem Eingangssignal phasenverschobenes Signal entsteht, aus dem das zweite Ausgangssignal des phasenschiebenden Netzwerkes gebildet wird.

2. Frequenzdiskriminator nach Anspruch 1, dadurch gekennzeichnet, daß ein zweiter und ein dritter Transistor (T2, T3) vorgesehen sind, daß ihre Basen an je einen Eingangsanschluß (A, B) angeschlossen sind, daß ihre Emitter über einen Widerstand (R4) miteinander verbunden sind, daß in jeden Emitter jeweils ein Strom (I2, I3) eingeleitet wird, daß der Kollektor des zweiten Transistors (T2) über einen Widerstand (R3) mit der Versorgungsspannung (Vd) verbunden ist und daß der zweite Eingang (Y) des Multiplizierers (M) an die Kollektoren des ersten und zweiten Transistors (Tl, T2) angeschlossen ist.

3. Frequenzdiskriminator nach Anspruch 1, dadurch gekennzeichnet, daß ein zweiter und dritter Transistor (T2, T3) vorgesehen sind, daß ihre Basen an je einen Eingangsanschluß (A, B) angeschlossen sind, daß die Emitter des zweiten und dritten Transistors (T2, T3) über eine Reihenschaltung zweier Widerstände (R4a, R4b) miteinander verbunden sind und daß am Verbindungspunkt ein Strom (I2) eingeleitet wird, daß der Kollektor des dritten Transistors (T3) über einen Widerstand (R5) mit der Versorgungsspannung (Vd) verbunden ist und daß das Signal für den ersten Eingang (X) des Multiplizierers (M) an den Kollektoren des zweiten und dritten Transistors (T2, T3) entnommen wird.

4. Frequenzdiskriminator nach Anspruch 3, dadurch gekennzeichnet, daß an den Kollektoren des ersten und zweiten Transistors (T1, T2) Emitterfolger (T4, T5) angeschlossen sind und daß die Ausgänge der Emitterfolger mit dem zweiten Eingang (Y) des Multiplizierers (M) verbunden sind.

## Claims

1. Frequency discriminator for integrated circuits for demodulation of a frequency-modulated input signal, consisting of a phase-shifting network and a multiplication circuit (M), wherein the phase-shifting network comprises a symmet- rical input (A, B) for the input signal to be demodulated, a terminal (C) for connection of a resonator (KR) which acts inductively in the working frequency range, a first output which is connected to the input (A, B) either directly or by way of a buffer stage so that the signal voltage thereof has no or only a slight phase shift relative to the input signal, and a second output, the signal voltage of which is phase-shifted with respect to the input signal depending upon the frequency, the multiplication circuit (M) has two inputs (X, Y) and an output (Z) and each input (X, Y) of the multiplication circuit is connected in each case to an output of the phase-shifting network, and the demodulated output signal can be tapped at the output (Z) of the multiplication circuit, characterised in that a first transistor (T1) is connected at the base to an input terminal (A), at the emitter to a current source (I1) and by way of a resistor (R1) to the connecting terminal (C) for the resonator (KR), and is connected at the collector by way of a working resistor (R2) to a supply voltage (Vd), so that by way of the working resistor (R2) a signal is produced which is phase-shifted relative to the input signal and from which the second output signal of the phase-shifting network is formed.

2. Frequency discriminator according to Claim 1, characterised in that a second and a third transistor (T2, T3) are provided, that the bases thereof are connected in each case to an input terminal (A, B), that the emitters thereof are connected to one another by way of a resistor (R4), that a current (I2, I3) is introduced into each emitter, that the collector of the second transistor (T2) is connected by way of a resistor (R3) to the supply voltage (Vd), and that the second input (Y) of the multiplier (M) is connected to the collectors of the first and second transistor (T1, T2).

3. Frequency discriminator according to Claim 1, characterised in that a second and third transistor (T2, T3) are provided, that the bases thereof are connected in each case to an input terminal (A, B), that the emitters of the second and third transistor (T2, T3) are connected to one another by way of a series connection of two resistors (R4a, R4b), and that a current (I2) is introduced at the connection point, that the collector of the third transistor (T3) is connected by way of a resistor (R5) to the supply voltage (Vd), and that the signal for the first input (X) of the multiplier (M) is tapped at the collectors of the second and third transistors (T2, T3).

4. Frequency discriminator according to Claim 3, characterised in that emitter followers (T4, T5) are connected to the collectors of the first and second transistor (T1, T2) and that the outputs of the emitter followers are connected to the second input (Y) of the multiplier (M).

## Revendications

1. Discriminateur de fréquence pour circuits intégrés pour la démodulation d'un signal d'entrée modulé en fréquence, constitué d'un circuit déphaseur et d'un circuit multiplicateur (M), discriminateur dans lequel le réseau déphaseur présente une entrée symétrique (A, B) pour le signal d'entrée à démoduler, une borne de connexion (C) pour connecter un résonateur (KR) qui se comporte en inductif sur la plage de fréquence de travail, une première sortie qui est reliée à l'entrée (A, B) soit directement soit par l'intermédiaire d'un étage tampon de façon que la tension de son signal ne présente pas de décalage de phase par rapport au signal d'entrée, ou seulement un faible décalage, ainsi qu'une seconde sortie dont la tension du signal est décalée en phase en fonction de la fréquence par rapport au signal d'entrée, dans lequel le circuit multiplicateur (M) présente deux entrées (X, Y) et une sortie (Z) et dans lequel chacune des entrées (X, Y) du circuit multiplicateur est reliée avec l'une, différente, des sorties du circuit déphaseur, et dans lequel on peut prélever le signal de sortie démodulé à la sortie (Z) du circuit multiplicateur, discriminateur caractérisé par le fait qu'un premier transistor (T1) est relié, par sa base, à une borne d'entrée (A), par son émetteur, à une source de courant (I1) et, par l'intermédiaire d'une résistance (R1), à la borne de connexion (C) pour le résonateur (KR) et, par son collecteur, par l'intermédiaire d'une résistance de travail (R2), à une tension d'alimentation (Vd), de façon qu'aux bornes de la résistance de travail (R2) apparaisse un signal qui est décalé en phase par rapport au signal d'entrée et à partir duquel est formé le second signal de sortie du circuit déphaseur.

2. Discriminateur de fréquence selon la revendication 1, caractérisé par le fait que sont prévus un deuxième et un troisième transistors (T2, T3), que leurs bases sont, chacune, reliées à une connexion d'entrée (A, B), que leurs émetteurs sont reliés l'un à l'autre par l'intermédiaire d'une résistance (R4), que dans chaque émetteur on fait passer respectivement un courant (I2, I3), que le collecteur du second transistor (T2) est relié à la tension d'alimentation (Vd) par l'intermédiaire d'une résistance (R3) et que la seconde entrée (Y) du multiplicateur (M) est reliée aux collecteurs du premier et du second transistors (T1, T2).

3. Discriminateur de fréquence selon la revendication 1, caractérisé par le fait que sont prévus un deuxième et un troisième transistors (T2, T3), que leurs bases sont, chacune, reliées à une connexion d'entrée (A, B), que les émetteurs du deuxième et du troisième transistors (T2, T3) sont reliés l'un à l'autre par l'intermédiaire d'un circuit de série de deux résistances (54a, R4b) et que l'on fait passer un courant (I2) au point de liaison, que le collecteur du troisième transistor (T3) est relié à la tension d'alimentation (Vd) par l'intermédiaire d'une résistance (R5) et que l'on prélève le signal pour la première entrée (X) du multiplicateur (M) aux collecteurs du deuxième et du troisième transistors (T2, T3).

4. Discriminateur de fréquence selon la revendication 3, caractérisé par le fait qu'aux collecteurs du premier et du deuxième transistors (T1, T2) sont reliés des montages émetteurs-suiveurs (T4, T5) et que les sorties des montages émetteurs-suiveurs sont reliées avec la seconde entrée (Y) du multiplicateur (M).
